# EUROPÄISCHE PATENTSCHRIFT

(11) **EP 3 698 147 B1**
(45) Veröffentlichungstag und Bekanntmachung des Hinweises auf die Patenterteilung: **17.02.2021**
(21) Anmeldenummer: 18796108.1
(22) Anmeldetag: 02.10.2018
(51) Int. Cl.: G01R 1/04, G01R 11/04, G01R 11/24, G01R 22/06

(54) **MEHRTEILIGES GEHÄUSE FÜR VERBRAUCHSZÄHLER SOWIE SICHERUNGSEINRICHTUNG FÜR MEHRTEILIGE GEHÄUSE**
MULTIPART HOUSING FOR CONSUMPTION METERS, AND A SECURING DEVICE FOR MULTIPART HOUSINGS
BOÎTIER EN PLUSIEURS PARTIES POUR COMPTEUR DE CONSOMMATION ET DISPOSITIF DE SÉCURITÉ POUR BOÎTIER EN PLUSIEURS PARTIES

(30) Priorität: 16.10.2017 CH 12592017
(43) Veröffentlichungstag der Anmeldung: 26.08.2020
(73) Patentinhaber: Landis+Gyr AG, 6301 Zug (CH)
(72) Erfinder: PETERHANS, Reto, 5412 Gebenstorf (CH)
(74) Vertreter: IPrime Rentsch Kaelin AG
(86) Internationale Anmeldenummer: PCT/IB2018/057635
(87) Internationale Veröffentlichungsnummer: WO 2019/077428

(56) Entgegenhaltungen:
- EP-A1- 1 659 411
- EP-A1- 2 273 276
- EP-A1- 2 762 899
- DE-A1-102006 050 700

## Beschreibung

Die vorliegende Erfindung bezieht sich auf das Gebiet der mehrteiligen Gehäuse zur Aufnahme von Verbrauchszählern. Sie betrifft ferner Sicherungseinrichtungen, um mehrteilige Gehäuse zur Aufnahme von Verbrauchszählern gegen unbefugtes Öffnen zu schützen.

### Technologischer Hintergrund

Mehrteilige Gehäuse zur Aufnahme von Verbrauchszählern sind aus dem Stand der Technik bekannt. Um diese Gehäuse gegen unbefugtes Öffnen zu sichern, werden Schraubverbindungen verwendet, welche die Gehäuseteile miteinander verbinden, wobei die Schraubverbindungen beispielsweise verriegelt oder durch Plomben gegen unbefugtes Lösen gesichert werden. Beim Zusammenbau des mehrteiligen Gehäuses sind zum Sichern des Gehäuses also mehrere Teile und zum Beispiel eine Schraube, ein Schraubendreher, ein Schlüssel und/oder eine Plombe mit einer Presszange zu handhaben, wodurch sich der Zusammenbau des Gehäuses erschwert. Ferner erhöhen die vielen Teile die Kosten für das Gehäuse.

Beispielweise zeigt EP 2 762 899 A1 einen Elektrizitätszähler mit einem unteren Gehäuseteil und einem oberen Gehäuseteil, wobei das untere Gehäuseteil erste Verriegelungselemente und das obere Gehäuseteil zweite Verriegelungselemente aufweist oder umgekehrt, wobei die ersten Verriegelungselemente und die zweiten Verriegelungselemente dazu ausgebildet sind, beim Zusammensetzen der beiden Gehäuseteile ineinander einzurasten, so dass sie sich anschliessend im Inneren eines von den beiden Gehäuseteilen gebildeten, geschlossenen Gehäuses befinden.

EP 1 659 411 A1 zeigt einen elektronischen Elektrizitätszähler, mit einem quaderförmigen Gehäuse, das alle Komponenten und Bauteile eines elektronischen Zählwerks enthält einschliesslich einer Leiterplatte mit Display und Stromsensoren und das lösbar mit einer Zählerplattform verbindbar ist, wobei die Zählerplattform Anschlussmittel für die Phasen der Versorgungsleitungen enthält und mit den Stromsensoren zusammenwirkende Leiterabschnitte, die mit Kontakten der Zählerplattform zusammenwirken, wenn das Gehäuse auf die Plattform aufgesetzt ist, und einem plombierbaren Plombierelement, das sich durch das Gehäuse hindurch erstreckt und das Gehäuse an der Plattform verriegelt.

### Darstellung der Erfindung

Es ist eine Aufgabe der Erfindung, ein mehrteiliges Gehäuse zur Aufnahme eines Verbrauchszählers, beispielsweise ein Stromzähler oder eine Wasseruhr, bereitzustellen, das preiswert hergestellt und einfach zusammengebaut werden kann, wobei das mehrteilige Gehäuse wirksam gegen unbefugtes Öffnen sicherbar ist.

Diese Aufgabe wird gelöst durch ein erfindungsgemässes mehrteiliges Gehäuse zur Aufnahme eines Verbrauchszählers, mit einem eine Rasteinrichtung aufweisenden ersten Gehäuseteil und einem eine Gegenrasteinrichtung aufweisenden zweiten Gehäuseteil, wobei die Rasteinrichtung und die Gegenrasteinrichtung eine Rastverbindung miteinander ausbilden, um das erste Gehäuseteil und das zweite Gehäuseteil aneinander zu fixieren, und wobei die Rasteinrichtung ein Halteelement zum Halten einer die Rastverbindung sichernden Sicherungseinrichtung aufweist. Ferner wird die Aufgabe durch eine Sicherungseinrichtung zur Sicherung der Rastverbindung des erfindungsgemässen mehrteiligen Gehäuses gelöst, wobei die Sicherungseinrichtung einen Handhabungskopf und ein Sicherungselement aufweist, und wobei das Sicherungselement vom Handhabungskopf entlang seiner Längsrichtung vorspringt und ein quer zur Längsrichtung verlaufendes Gegenhalteelement zur Fixierung der Sicherungseinrichtung in seiner Sicherungsposition aufweist.

Zum Herstellen der Rastverbindung reicht es also aus, die beiden Gehäuseteile zusammenzusetzen, sodass hierfür keine zusätzlichen Teile oder Werkzeuge notwendig sind. Das einzige Teil, dass zur Sicherung der Rastverbindung und somit zum Schutz des mehrteiligen Gehäuses gegen unbefugtes Öffnen benötigt wird, ist die Sicherungseinrichtung, die einfach handhabbar ist.

Die Lösung kann durch verschiedene, jeweils für sich vorteilhafte und, sofern nicht anders ausgeführt, beliebig miteinander kombinierbare Ausgestaltungen weiter verbessert werden. Auf diese Ausgestaltungsformen und die mit ihnen verbundenen Vorteile ist im Folgenden eingegangen.

Gemäss einer ersten weiteren Ausgestaltungsform ist das Halteelement ein von der Gegenrasteinrichtung weg vorspringender Rastvorsprung. Das Gegenhalteelement kann folglich komplementär zum Halteelement und beispielsweise als ein Halterücksprung oder als eine Halteöffnung ausgebildet sein, sodass das Sicherungselement ohne quer zu seiner Längsrichtung vorspringende Elemente, welche die Handhabung der Sicherungseinrichtung erschweren können, ausgebildet sein kann.

Gemäss einer weiteren Ausgestaltungsform weist die Rasteinrichtung ein freies Ende und eine dem freien Ende gegenüberliegendes festes Ende auf, wobei das Halteelement näher am festen Ende als am freien Ende angeordnet ist. Insbesondere wenn das freie Ende der Rasteinrichtung elastisch von seiner Rastposition in seine Freigabeposition auslenkbar ist, gewährleistet das näher am festen Ende angeordnete Halteelement eine stabilere Verbindung zwischen der Sicherungseinrichtung und der Rasteinrichtung, da die Rasteinrichtung in Richtung auf das feste Ende zu weniger beweglich ist. In der Rastposition ist die Rasteinrichtung mit der Gegenrasteinrichtung verrastet und bildet die Rastverbindung aus. In der Freigabeposition ist die Rastverbindung offen.

Gemäss einer weiteren Ausgestaltungsform weist die Rasteinrichtung ein Rastelement zum Verrasten mit einem Gegenrastelement der Gegenrasteinrichtung auf, wobei das Rastelement näher am freien Ende als am festen Ende angeordnet ist. Insbesondere wenn das freie Ende elastisch auslenkbar ist, können die aufzuwendenden Rastkräfte zur Herstellung der Rastverbindung gering gehalten werden, wenn das Rastelement näher am freien Ende als am festen Ende angeordnet ist.

Gemäss einer weiteren Ausgestaltungsform ist das Gegenhalteelement näher an einem freien Ende des Sicherungselementes als am Handhabungskopf angeordnet, sodass das Halteelement und das Gegenhalteelement des in das Gehäuse eingesetzten Sicherungselementes, wenn überhaupt nur schwer erreichbar und somit gegen Manipulation gesichert im Gehäuse angeordnet sind.

Gemäss seiner weiteren Ausgestaltungsform weist das mehrteilige Gehäuse eine Führungseinrichtung für die Sicherungseinrichtung auf. Die Führungseinrichtung und die Rasteinrichtung begrenzen zumindest im geschlossenen Zustand der Rastverbindung einen Aufnahmespalt für die die Rastverbindung sichernde Sicherungseinrichtung. Der Aufnahmespalt führt die Sicherungseinrichtung und insbesondere das Sicherungselement, wenn dieses in den Aufnahmespalt angesetzt wird, sodass die Sicherungseinrichtung einfach montiert werden kann.

Gemäss einer weiteren Ausgestaltungsform nimmt die lichte Weite des Aufnahmespaltes in der Aufnahmerichtung zumindest teilweise ab. Folglich kann der Aufnahmespalt zumindest abschnittsweise einen trichterförmigen Querschnitt aufweisen, der sich entgegen der Aufnahmerichtung weitet, und dadurch das Einsetzen der Sicherungseinrichtung in den Aufnahmespalt weiter vereinfacht und die Sicherungseinrichtung beim Einsetzen noch besser führt.

Gemäss einer weiteren Ausgestaltungsform weist der Aufnahmespalt eine Einsetzöffnung auf, durch die die Sicherungseinrichtung in den Aufnahmespalt einsetzbar ist. Die Einsetzöffnung weist vom ersten Gehäuseteil weg, sodass die Sicherungseinrichtung in Richtung auf das erste Gehäuseteil und insbesondere in Richtung auf die durch die Rasteinrichtung und die Gegenrasteinrichtung ausgebildete Rastverbindung in den Aufnahmespalt einsetzbar ist.

Gemäss einer weiteren Ausführungsform weist das Sicherungselement eine Sollbruchstelle auf, die ausgeformt ist, bei Belastung quer zur Längsrichtung eher zu brechen, als an die Sollbruchstelle angrenzende Abschnitte des Sicherungselementes.

Folglich kann zum Öffnen des mehrteiligen Gehäuses beziehungsweise zum Trennen der beiden Gehäuseteile des Gehäuses voneinander dass Sicherungselement an der Sollbruchstelle zerbrochen und somit zerstört werden. Zwar ist das Gehäuse dann nicht mehr gegen unbefugtes Öffnen gesichert. Allerdings lässt sich anhand des Zustandes des Sicherungselementes beurteilen, ob das Gehäuse vor einer Inspektion des Sicherungselementes unbefugt geöffnet wurde.

Gemäss einer weiteren Ausgestaltungsform weist der Aufnahmespalt eine Auswurföffnung auf, die zum ersten Gehäuseteil hin weist. Entlang der Aufnahmerichtung können die Einsetzöffnung und die Auswurföffnung einander gegenüberliegend angeordnet sein. Der zwischen der Sollbruchstelle und dem freien Ende des Sicherungselementes angeordnete Abschnitt des Sicherungselementes kann also durch die Auswurföffnung aus dem Aufnahmespalt ausgeworfen werden, insbesondere wenn die Auswurföffnung ein unteres Ende des Aufnahmespaltes ausbildet. Der das freie Ende umfassende und an der Sollbruchstelle abgebrochene Abschnitt des Sicherungselementes kann also durch die Auswurföffnung fallen, um ein Öffnen der Rastverbindung nicht zu behindern.

Gemäss einer weiteren Ausgestaltungsform sind die Rasteinrichtung, die Gegenrasteinrichtung und die Führungseinrichtung quer zur Aufnahmerichtung jeweils zumindest abschnittsweise elastisch auslenkbar. Durch die elastische Auslenkbarkeit der Rastvorrichtung und der Gegenrastvorrichtung lässt sich die Rastverbindung einfach herstellen. Dadurch, dass auch die Führungseinrichtung quer zur Aufnahmerichtung elastisch auslenkbar ist, kann diese das Sicherungselement bereits beim Einsetzen des Sicherungselementes in Richtung auf die Rasteinrichtung drücken, um die Verbindung zwischen dem Halteelement und den Gegenhalteelement sicher herzustellen.

Gemäss einer weiteren Ausgestaltungsform ist das Sicherungselement quer zu seiner Längsrichtung elastisch verformbar, insbesondere durch beim Einsetzen des Sicherungselementes in den Aufnahmespalt auftretende Kräfte. Wird nun versucht, die Verbindung zwischen dem Halteelement und den Gegenhalteelement durch verformen der Rastvorrichtung, der Gegenwartsvorrichtung, der Führungseinrichtung und/oder des Sicherungselementes von ausserhalb des Gehäuses zu lösen, verformen sich die Rasteinrichtung, die Gegenrasteinrichtung und die Führungseinrichtung sowie das Sicherungselement gemeinsam und können einen Pressverbund miteinander ausbilden. Das Rastelement und das Gegenrastelement können also durch das Sicherungselement bewegungsübertragend mit der Führungseinrichtung verbunden sein. Die Verformung von aussen führt folglich nicht ohne weiteres zur Lösung des Halteelementes vom Gegenhalteelement oder zur Öffnung der Rastverbindung.

Gemäss einer weiteren Ausgestaltungsform weist das zweite Gehäuseteil eine durchgehende Öffnung auf, die die Umgebung des mehrteiligen Gehäuses mit dem Aufnahmespalt verbindet. Ferner weist gemäss einer Ausgestaltungsform die Sicherungseinrichtung und beispielsweise deren Handhabungskopf eine durchgehende Öffnung auf, die im vollständig eingesetzten Zustand der Sicherungseinrichtung, also wenn die Sicherungseinrichtung in ihrer Sicherungsposition angeordnet ist und die Rastverbindung sichert, den Aufnahmespalt und/oder die durchgehende Öffnung des zweiten Gehäuseteils mit der Umgebung des mehrteiligen Gehäuses verbindet. Durch die durchgehenden Öffnungen kann ein auf den Verbrauchszähler zugreifender Handwerker oder Techniker zum Beispiel einen Sicherungsfaden führen, der ausserhalb des Gehäuses durch eine Plombe gesichert wird, sodass das mehrteilige Gehäuse zusätzlich zur Sicherungseinrichtung gegen unbefugtes Öffnen geschützt ist.

Gemäss einer weiteren Ausgestaltungsform bildet das zweite Gehäuseteil einen die Einsetzöffnung quer zur Aufnahmerichtung begrenzenden Rand aus. Der Rand weist einen sich entgegen der Aufnahmerichtung öffnenden und die Aufnahmerichtung zumindest teilweise oder sogar vollständig umlaufenden Aufnahmekanal aus.

Gemäss einer weiteren Ausgestaltungsform weist die Sicherungseinrichtung und insbesondere deren Handhabungskopf einen sich in der Längsrichtung des Sicherungselementes erstreckenden und die Längsrichtung zumindest teilweise oder sogar vollständig umlaufenden Kragen auf. Der Kragen kann im Wesentlichen komplementär zum Aufnahmekanal ausgebildet und in diesen einsetzbar sein, um die Position des Handhabungskopf im Aufnahmespalt und insbesondere in der Einsetzöffnung präzise zu definieren.

Gemäss einer weiteren Ausgestaltungsform ist zwischen dem Kragen und einem zentralen Abschnitt des Handhabungskopfes ein Einsetzkanal angeordnet, in den der Rand einsetzbar ist. Der Einsetzkanal öffnet sich in der Längsrichtung. Hierdurch verbessert sich die Positionierbarkeit des Sicherungselementes weiter.

Gemäss einer weiteren Ausgestaltungsform umlaufen der Rand und somit auch der Aufnahmekanal die Aufnahmerichtung Ferner umläuft auch der Kragen die Längsrichtung vollständig. Der Rand und der Aufnahmekanal sowie der Kragen und der Einsetzkanal können gemeinsam eine Dichteinrichtung ausbilden.

Gemäss einer weiteren Ausgestaltungsform weist der sich in der Längsrichtung öffnende Einsetzkanal an seinem entgegen der Längsrichtung angeordneten Grund eine Vertiefung auf, die zusammen mit dem Einsatzkanal zumindest teilweise oder sogar vollständig die Längsrichtung umläuft. Die Vertiefung definiert eine Sollbruchstelle des Handhabungskopfes, entlang der der zentrale Abschnitt aus dem Handhabungskopf ausgebrochen werden kann. Hierdurch lässt sich die zum Zerbrechen der Sollbruchstelle der Sicherungseinrichtung benötigte Kraft einfacher und effektiver in die Sicherungseinrichtung einleiten, insbesondere wenn die Sicherungseinrichtung am zentralen Abschnitt befestigt ist.

Gemäss einer weiteren Ausgestaltungsform ist die Sicherungseinrichtung dorn-, spiess-, stab- oder balkenförmig ausgeformt.

Das mehrteilige Gehäuse und die Sicherungseinrichtung können jeweils separat oder zu einem sicherbaren mehrteiligen Gehäuse kombiniert bereitgestellt sein.

### Kurze Beschreibung der Zeichnungen

Zum besseren Verständnis der vorliegenden Erfindung wird nachfolgend auf die Zeichnungen Bezug genommen. Die Zeichnungen zeigen lediglich Ausführungsbeispiele des Erfindungsgegenstandes. Merkmale dieser Ausführungsbeispiele sind unabhängig voneinander kombinierbar. In den Figuren und der dazugehörigen Beschreibung sind gleiche oder gleichwirkende Teile mit gleichen Bezugszeichen versehen.

Anhand der nachfolgenden Figuren werden Ausführungsbeispiele der Erfindung beschrieben. Es zeigen:
- Figur 1: eine schematische Schnittdarstellung eines Ausführungsbeispiels eines erfindungsgemässen mehrteiligen Gehäuses,
- Figur 2: eine perspektivische Teildarstellung des Ausführungsbeispiels der Figur 1 mit einem Ausführungsbeispiel einer erfindungsgemässen Sicherungseinrichtung,
- Figur 3: eine weitere perspektivische Teildarstellung der Ausführungsbeispiele der Figur 2,
- Figur 4: eine schematische Schnittdarstellung der Ausführungsbeispiele der Figur 3,
- Figur 5: eine weitere perspektivische Teiledarstellung der Ausführungsbeispiele der Figuren 2 bis 4,
- Figur 6: eine schematische Darstellung der in der Figur 5 dargestellten Ausführungsbeispiele,
- Figur 7: eine weitere perspektivische Teildarstellung der Ausführungsbeispiele der Figuren 2 bis 6 mit einer Plombe,
- Figur 8: eine weitere schematische Schnittdarstellung der Ausführungsbeispiele der Figuren 2 bis 6 mit einem Werkzeug zum Zerbrechen der Sicherungseinrichtung, und
- Figur 9: eine weitere schematische Schnittdarstellung der Ausführungsbeispiele der Figur 8 mit der zerbrochenen Sicherungseinrichtung.

### Wege zur Ausführung der Erfindung

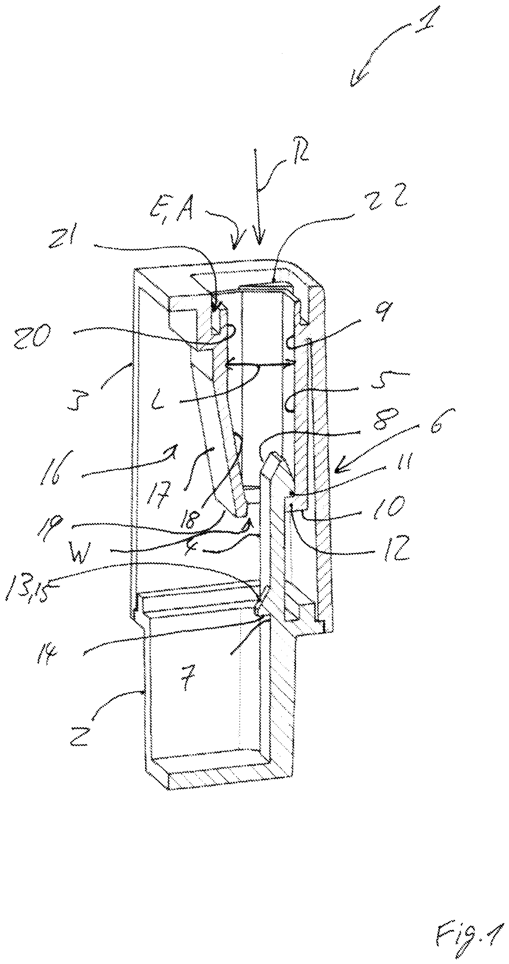

Ein erstes mögliches Ausführungsbeispiel eines erfindungsgemässen mehrteiligen Gehäuses 1 zur Aufnahme eines Verbrauchszählers ist in der Figur 1 dargestellt. Das mehrteilige Gehäuse 1 weist ein erstes Gehäuseteil 2 und ein zweites Gehäuseteil 3 auf. Die beiden Gehäuseteile 2, 3 sind im einem zusammengesetzten Zustand dargestellt, in dem das mehrteilige Gehäuse 1 geschlossen ist. Die beiden Gehäuseteile 2, 3 können Gehäuseschalen oder Gehäusehälften sein. Alternativ kann eines der Gehäuseteil 2, 3 ein Deckel des mehrteiligen Gehäuses 1 und das verbleibende Gehäuseteil 2, 3 ein Teil einer Gehäuseschale oder eine vollständige Gehäuseschale sein.

Um zu verhindern, dass sich die beiden Gehäuseteil 2, 3 ungewollt voneinander lösen, weist das erste Gehäuseteil 2 eine Rasteinrichtung 4 und das zweite Gehäuseteil 3 eine Gegenrasteinrichtung 5 auf, die miteinander eine Rastverbindung 6 ausbilden, wobei die Rastverbindung 6 die Gehäuseteil 2, 3 aneinander befestigt. Aufgrund der im Ausführungsbeispiel der Figur 1 dargestellten geschlossenen Rastverbindung 6 können die Gehäuseteile 2, 3 nicht ohne weiteres voneinander entfernt werden, sodass die Gehäuseteile 2, 3 beispielsweise unverlierbar miteinander verbunden sind.

Die Rasteinrichtung 4 ist beispielhaft als eine Rastlasche mit einem festen Ende 7 und einem freien Ende 8 dargestellt. Das feste Ende 7 ist im Wesentlichen unbewegbar an einer Wandung des ersten Gehäuseteils 2 angebracht. Das freie Ende 8 hingegen ist im Ausführungsbeispiel der Figur 1 elastisch auslenkbar und in seiner Rastposition dargestellt. Alternativ zum Ausführungsbeispiel der Figur 1 kann die Rasteinrichtung 4 elastisch und zum Beispiel über eine Feder an der Wandung des ersten Gehäuseteil 2 gelagert sein, sodass die Rasteinrichtung 4 um eine Ruheposition hin und her bewegbar war ist.

Die Gegenrasteinrichtung 5 ist beispielhaft ebenfalls als eine Rastlasche mit einem festen Ende 9 und einem freien Ende 10 dargestellt. Das feste Ende 9 ist im Wesentlichen unbewegbar an einer Wandung des zweiten Gehäuseteils 3 angebracht. Das freie Ende 10 hingegen ist im Ausführungsbeispiel der Figur 1 elastisch auslenkbar. Alternativ zum Ausführungsbeispiel der Figur 1 kann die Gegenrasteinrichtung 5 elastisch und zum Beispiel über eine Feder an der Wandung des zweiten Gehäuseteil 3 gelagert sein, sodass die Gegenrasteinrichtung 5 um eine Ruheposition hin und her bewegbar war ist.

Das freie Ende 8 der Rasteinrichtung 4 kann sich in seinem Verlauf weg vom festen Ende 7 der Rasteinrichtung 4 verjüngen und eine Spitze mit wenigstens einer und insbesondere mit zwei Schrägen ausbilden. Die wenigstens eine Schräge kann im in der Figur 1 dargestellten zusammengebauten Zustand des mehrteiligen Gehäuses 1 zur Gegenrasteinrichtung 5 weisen. Weist die Spitze zwei Schrägen auf, so kann eine der Schrägen zur Gegenrasteinrichtung 5 und die andere der Schrägen weg von der Gegenrasteinrichtung 5 weisen. Die zur Gegenrasteinrichtung 5 weisende Schräge verhindert ein Verkanten der Rasteinrichtung 4 mit der Gegenrasteinrichtung 5 beim Zusammenbau des mehrteiligen Gehäuses 1 und beim Schliessen der Rastverbindung 6. Die von der Gegenrasteinrichtung 5 weg weisende Schräge verhindert ein Verkanten der Rasteinrichtung 4 mit der Sicherheitseinrichtung, wenn diese in ihre Sicherungsposition bewegt wird.

Die Rasteinrichtung 4 weist ein Rastelement 11 und die Gegenrasteinrichtung 5 ein Gegenrastelement 12 auf. Das Rastelement 11 und das Gegenrastelement 12 sind im Ausführungsbeispiel der Figur 1 miteinander verrastet und bilden somit die die beiden Gehäuseteile 2, 3 aneinander fixierende Rastverbindung 6. Beispielhaft sind das Rastelement 11 und das Gegenrastelement 12 als auf einander zu vorspringende Rastvorsprünge dargestellt. Alternativ kann das Rastelement 11 oder das Gegenrastelement 12 durch einen Rastrücksprung und/oder eine Rastöffnung ausgebildet sein.

Das Rastelement 11 und das Gegenrastelement 12 sind beispielhaft im Bereich der freien Enden 8, 10 der Rasteinrichtung 4 beziehungsweise der Gegenrasteinrichtung 5 angeordnet. Die Rasteinrichtung 4 ist mit einem Halteelement 13 zum Halten einer die Rastverbindung 6 sichernden Sicherungseinrichtung versehen. Das Halteelement 13 ist beispielhaft als ein Halte- oder Rastvorsprung ausgebildet, kann jedoch alternativ auch als ein Rücksprung oder als eine Öffnung in der Rasteinrichtung 4 ausgeformt sein. Insbesondere ist das Halteelement 13 wie im Ausführungsbeispiel der Figur 1 dargestellt auf einer Seite der Rasteinrichtung 4 angeordnet, die der Seite, auf der das Rastelement 11 angeordnet ist, gegenüberliegt. Sind das Rastelement 11 und das Halteelement 13 jeweils als ein vorspringendes Element ausgestaltet, so können sich das Rastelement 11 und das Halteelement 13 in entgegengesetzte Richtungen erstrecken und insbesondere in diesen Richtungen vorstehen.

Das Halteelement 13 weist eine vom freien Ende 8 wegweisende Haltefläche 14 und eine vom festen Ende 7 weg weisende Führungsfläche 15 auf. Die Führungsfläche 15 ist schräg ausgebildet, um ein Einsetzen der Sicherungseinrichtung zu vereinfachen. Die Haltefläche 14 ist ausgebildet, ein Entfernen der Sicherungseinrichtung, wenn diese zumindest abschnittsweise an der Haltestelle 14 anliegt, zu verhindern. Ein solches Halteelement 13 kann auch als Halte- oder Rastnase bezeichnet werden.

Das mehrteilige Gehäuse 1 und insbesondere dessen zweiter Gehäuseteil 3 ist mit einer Führungseinrichtung 16 versehen dargestellt. Zwischen der Führungseinrichtung 16 und der Rasteinrichtung 4 beziehungsweise der Gegenrasteinrichtung 5 befindet sich ein Aufnahmespalt A zur zumindest abschnittsweisen Aufnahme der Sicherungseinrichtung. Insbesondere zumindest im geschlossenen Zustand der Rastverbindung 6 begrenzen die Führungseinrichtung 16 und die Rasteinrichtung 4 beziehungsweise die Gegenrasteinrichtung 5 den Aufnahmespalt A quer zu einer Aufnahmerichtung R, in der die Sicherungseinrichtung in den Aufnahmespalt A einsetzbar ist.

Die quer zur Aufnahmerichtung R verlaufende lichte Weite L nimmt in der Aufnahmerichtung R zumindest abschnittsweise ab. Beispielsweise weist die Führungseinrichtung 16 einen Führungsabschnitt 17 auf, der schräg zur Aufnahmerichtung R verläuft und sich dabei der Rasteinrichtung 4 beziehungsweise der Gegenrasteinrichtung 5 in seinem Verlauf in der Aufnahmerichtung R angenähert. Eine der Rasteinrichtung 4 beziehungsweise der Gegenrasteinrichtung 5 zugewandte Führungsseite 18 der Führungseinrichtung 16 führt dabei die Sicherungseinrichtung, wenn diese in der Aufnahmerichtung R den Aufnahmespalt A eingesetzt wird.

Im Bereich der maximalen Annäherung der Führungseinrichtung 16 an die Rasteinrichtung 4 kann die lichte Weite L des Aufnahmespaltes A im Ausführungsbeispiel der Figur 1, in dem die Sicherungseinrichtung nicht dargestellt ist, geringer sein, als eine in derselben Richtung verlaufende Breite eines Abschnittes der Sicherungseinrichtung, der in diesem Bereich angeordnet ist, wenn die Sicherungseinrichtung die Rastverbindung 6 gesichert. Im Bereich der maximalen Annäherung kann die Führungseinrichtung 16 ein freies Ende 19 aufweisen.

Entgegen der Aufnahmerichtung R weist der Aufnahmespalt A eine Einsetzöffnung E auf, durch die die Sicherungseinrichtung in den Aufnahmespalt A einsetzbar ist. Im Bereich der maximalen Annäherung ist die lichte Weite grösser als null, sodass die Führungseinrichtung 16 nicht an der Rasteinrichtung 4 anliegt, sondern von dieser beabstandet angeordnet ist. In der Aufnahmerichtung R weist der Aufnahmespalt also eine Auswurföffnung W auf, durch die der Aufnahmespalt A in Richtung auf das erste Gehäuseteil 2 mündet.

Das zweite Gehäuseteil 3 ist mit einem die Einsetzöffnung E quer zur Aufnahmerichtung R begrenzenden Rand 20 versehen, wobei der Rand 20 eine sich entgegen der Aufnahmerichtung R öffnenden und die Aufnahmerichtung R zumindest teilweise oder sogar vollständig umlaufenden Aufnahmekanal 21 begrenzt. Insbesondere kann der Rand 20 quer zur Aufnahmerichtung R zwischen dem Aufnahmespalt A und dem Aufnahmekanal 21 angeordnet sein. Der Aufnahmekanal 21 kann nutenförmig ausgestaltet sein. Der Aufnahmekanal 21 kann Teil einer die Einsetzöffnung abdichtenden Dichteinrichtung sein.

Das mehrteilige Gehäuse 1 und insbesondere dessen zweites Gehäuseteil 3 kann mit einem Kodierelement 22 versehen sein, welches gewährleistet, dass die Sicherungseinrichtung richtig ausgerichtet in den Aufnahmespalt A eingesetzt wird. Im Ausführungsbeispiel der Figur 1 ist das Kodierelement 22 quer zur Aufnahmerichtung R neben dem Aufnahmespalt A angeordnet und begrenzt zusammen mit dem Rand 20 einen Teil des Aufnahmekanals 21 quer zur Aufnahmerichtung R.

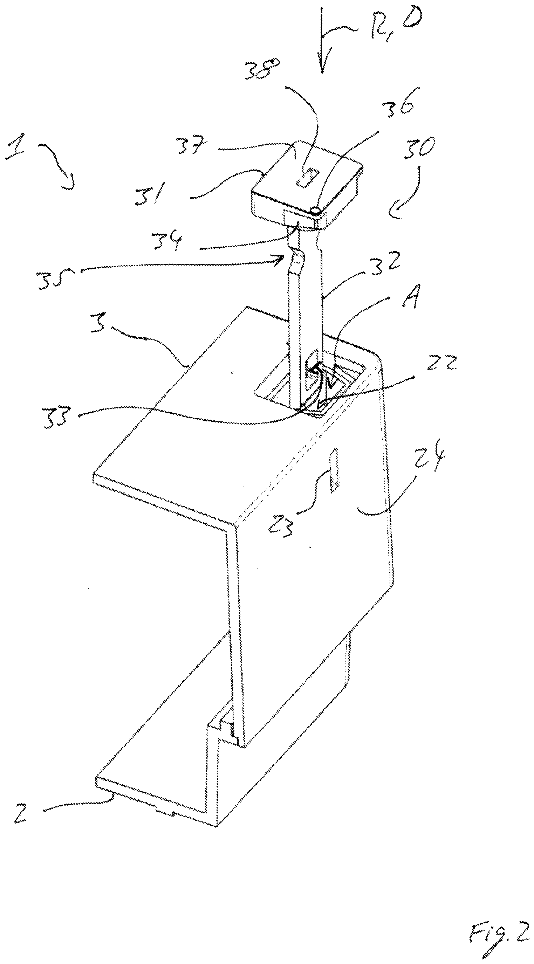

Figur 2 zeigt das Ausführungsbeispiel der Figur 1 mit einem Ausführungsbeispiel einer erfindungsgemässen Sicherungseinrichtung schematisch in einer perspektivischen Teildarstellung, wobei die Sicherungseinrichtung entlang der Aufnahmerichtung R nur unvollständig in den Aufnahmespalt A eingesetzt ist. Die Sicherungseinrichtung 30 zur Sicherung der Rastverbindung 6 des mehrteiligen Gehäuses 1 weist eine Handhabungskopf 31 und ein vom Handhabungskopf 31 entlang seiner Längsrichtung D vorspringendes Sicherungselement 32 auf. Während das Sicherungselement 32 in den Aufnahmespalt A eingesetzt wird oder ist, verlaufen die Aufnahmerichtung R und die Längsrichtung D parallel zu einander.

Das Sicherungselement 32 ist mit einem quer zur Längsrichtung D verlaufenden Gegenhalteelement 33 versehen, wobei das Gegenhalteelement 33 zur Fixierung der Sicherungseinrichtung 30 in seiner Sicherungsposition mit dem Halteelement 13 interagiert und mit diesem hierzu beispielsweise eine formschlüssige Verbindung, etwa eine Rastverbindung, eingeht. Das Gegenhalteelement 33 ist beispielhaft als eine sich quer zur Längsrichtung D zumindest teilweise oder sogar vollständig durch das Sicherungselement 32 ersteckende Öffnung dargestellt.

Der Handhabungskopf 31 weist ein Gegenkodierelement 34 auf, das wenigstens abschnittsweise komplementär zum Kodierelement 22 ausgeformt ist, um zu gewährleisten, dass die Sicherungseinrichtung 30 in ihrer Sicherungsposition richtig ausgerichtet ist. In der Sicherungsposition ist die Sicherungseinrichtung 30 in der Aufnahmerichtung R weiter als in der Figur 2 gezeigt und beispielsweise vollständig in den Aufnahmespalt A eingesetzt.

Zwischen dem Handhabungskopf 31 und dem Gegenhalteelement 33 weist das Sicherungselement 32 eine Sollbruchstelle 35 auf, die ausgebildet ist, bei mechanischer Belastung quer zur Längsrichtung D eher zu brechen, als an die Sollbruchstelle 35 angrenzende Abschnitte des Sicherungselementes 32.

Wie erst in der Figur 2 ersichtlich, kann das mehrteilige Gehäuse 1 und insbesondere dessen zweites Gehäuseteil 3 eine durchgehende Öffnung 23 aufweisen, die zum Beispiel in einer im Wesentlichen parallel zur Aufnahmerichtung R verlaufenden Seitenwand 24 des zweiten Gehäuseteils 3 angeordnet ist. Die durchgehende Öffnung 23 verbindet die Umgebung des mehrteiligen Gehäuses 1 mit dem Aufnahmespalt A.

Die Sicherungseinrichtung 30 und insbesondere deren Handhabungskopf 31 kann eine durchgehende Öffnung 36 aufweisen, die sich zum Beispiel wenigstens abschnittsweise in der Längsrichtung D durch den Handhabungskopf 31 erstreckt und in einer vom Sicherungselement 32 weg weisende Oberseite 37 mündet. In der Sicherungsposition endet die durchgehende Öffnung 36 im Aufnahmespalt A oder mündet in die durchgehende Öffnung 23, sodass ein Sicherungsfaden durch die durchgehenden Öffnungen 23, 36 geführt werden kann.

Die Sicherungseinrichtung 30 weist optional eine Werkzeugaufnahme 38 zur zumindest teilweisen Aufnahme eines Werkzeuges auf. Mit dem Werkzeug ist eine mechanische Kraft in die Sicherungseinrichtung 30 einbringbar, die die Sicherungseinrichtung 30 an die Sollbruchstelle 35 weiterleitet, um diese zu zerbrechen. Zum Beispiel ist die Werkzeugaufnahme in der Oberseite 37 angeordnet und als ein Schlitz ausgebildet sein, der sich entgegen der Längsrichtung D öffnet.

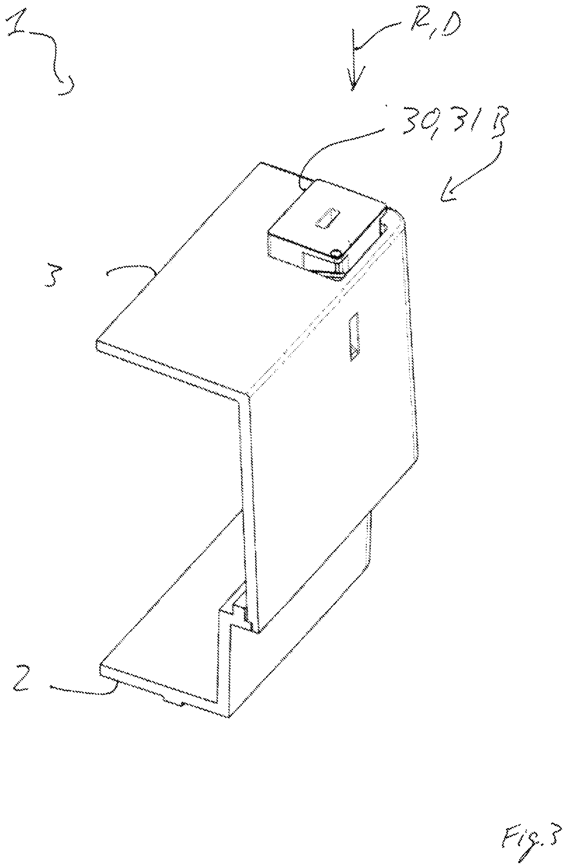

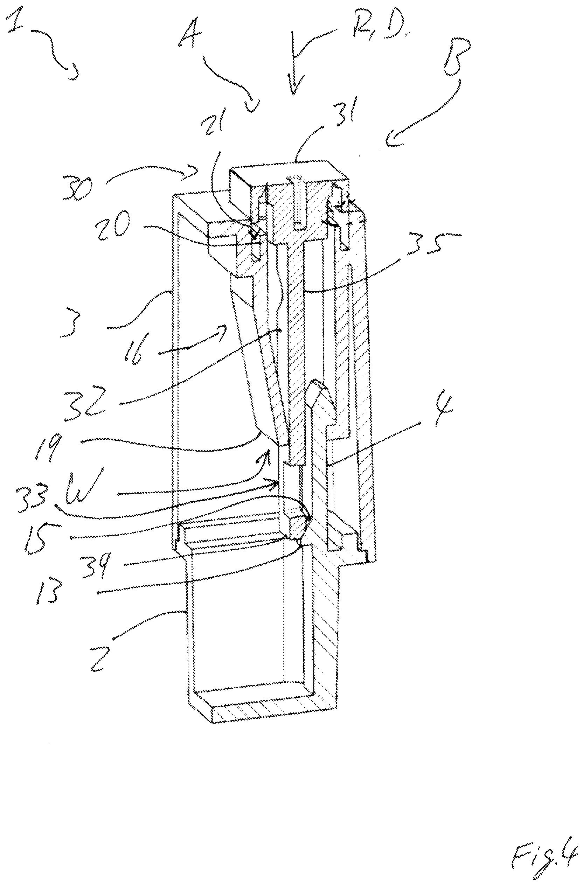

Figur 3 zeigt die Ausführungsbeispiele der Figur 2 in derselben schematischen Perspektivansicht, wobei die Sicherungseinrichtung 30 entlang der Aufnahmerichtung R weiter in den Aufnahmespalt A eingesetzt ist, sodass lediglich der Handhabungskopf 31 entgegen der Aufnahmerichtung R aus dem mehrteiligen Gehäuse 1 herausragt. Figur 4 zeigt die Ausführungsbeispiele der Figur 3 in einer schematischen Schnittansicht, wobei die Schnittebene parallel zur Aufnahmerichtung R verläuft. In den Figuren 3 und 4 ist die Sicherungseinrichtung 30 bis in ihre Bereitschaftsposition B in den Aufnahmespalt A eingesetzt. In der Bereitschaftsposition B liegt das Sicherungselement 32 am Halteelement 13 an, wobei das Gegenhalteelement 33 entlang der Aufnahmerichtung R beabstandet vom Halteelement 13 angeordnet ist. In der Bereitschaftsposition B kann die Sicherungseinrichtung 30 ohne weiteres entgegen der Aufnahmerichtung R aus dem Aufnahmespalt A entfernt werden.

Ein aus Sicht des Handhabungskopfes 31 entlang der Längsrichtung D hinter der Sollbruchstelle 35 gelegener Abschnitt des Sicherungselementes 32 ragt durch die Auswurföffnung W und ist insbesondere zwischen der Auswurföffnung W und/oder dem freien Ende 19 der Führungseinrichtung 16 und der Rasteinrichtung 4 angeordnet. Die Führungseinrichtung 16 kann zumindest abschnittsweise und insbesondere im Bereich ihres freien Endes 19 elastisch auslenkbar sein und das Sicherungselement 32 quer zur Aufnahmerichtung R gegen die Rasteinrichtung 4 drücken. Wird die Sicherungseinrichtung 30 entlang der Aufnahmerichtung R weiter in den Aufnahmespalt A bewegt, so sorgt die Führungsfläche 15 dafür, dass ein freies Ende 39 des Sicherungselementes 32 quer zur Aufnahmerichtung R weg von der Rasteinrichtung 4 gedrückt wird. Hat das freie Ende 39 das Halteelement 13 in der Aufnahmerichtung R überwunden oder passiert, so verrasten das Halteelement 13 und das Gegenhalteelement 33 in der Sicherungsposition der Sicherungseinrichtung 30 miteinander, sodass die Sicherungseinrichtung 30 nicht mehr entgegen der Aufnahmerichtung R aus dem Aufnahmespalt A entnehmbar ist. Beispielsweise greift das Halteelement 13in der Sicherungsposition in das Gegenhalteelement 33 ein.

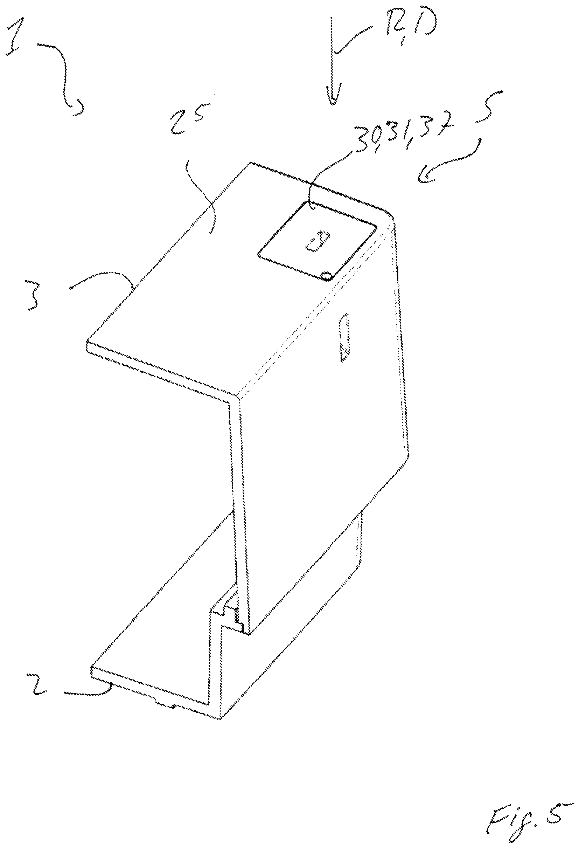

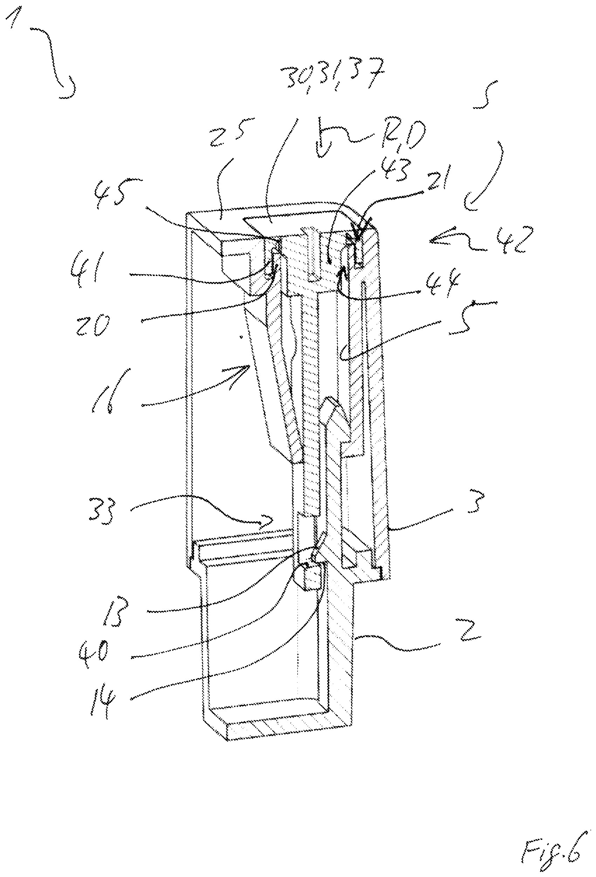

Figur 5 zeigt die Ausführungsbeispiele der Figuren 2 bis 4 in derselben schematischen Perspektivansicht, wobei die Sicherungseinrichtung 30 entlang der Aufnahmerichtung R weiter in den Aufnahmespalt A eingesetzt ist. Figur 6 zeigt die Ausführungsbeispiele der Figur 5 in einer schematischen Schnittansicht, wobei die Schnittebene parallel zur Aufnahmerichtung R verläuft. Figuren 5 und 6 zeigen die Sicherungseinrichtung 30 in ihrer Sicherungsposition S. In der Sicherungsposition S sind das Halteelement 13 und das Gegenhalteelement 33 so miteinander verrastet, dass die Sicherungseinrichtung 30 nicht ohne weiteres entgegen der Aufnahmerichtung R aus dem Aufnahmespalt A entnehmbar ist. Vielmehr blockiert die Haltefläche 14 ein Bewegen der Sicherungseinrichtung 30 entgegen der Aufnahmerichtung R relativ zum ersten Gehäuseteil 2. Hierzu liegt die Haltefläche 14 beispielsweise an einer parallel zur Haltefläche 14 verlaufenden Gegenhaltefläche 40 des Gegenhalteelementes 33 an. Die Haltefläche 14 verläuft zum Beispiel quer zur Aufnahmerichtung R.

Um ein Entfernen der Sicherungseinrichtung 30 entgegen der Aufnahmerichtung R aus dem Aufnahmespalt A zu erschweren, kann die Oberseite 37 fluchtend mit einer Aussenseite 25 des mehrteiligen Gehäuses 1 und beispielsweise des zweiten Gehäuseteils 3 angeordnet sein, wenn die Sicherungseinrichtung 30 in ihrer Sicherungsposition S angeordnet ist. Die Einsetzöffnung E ist dann in der Aussenseite 25 angeordnet. Beispielsweise ist die Aussenseite 25 eine Oberseite des mehrteiligen Gehäuses 1, die entgegen die Schwerkraft weisend ausgerichtet ist, wenn das mehrteilige Gehäuse 1 im Einsatz montiert ist.

Die Rasteinrichtung 4, die Gegenrasteinrichtung 5, die Führungseinrichtung 16 und die Sicherungseinrichtung 30 können quer zur Aufnahmerichtung R beziehungsweise zur Längsrichtung D elastisch verform- oder auslenkbar sein. Ist die Sicherungseinrichtung 30 in ihrer Sicherungsposition S angeordnet, können die Rasteinrichtung 4, die Gegenrasteinrichtung 5, die Führungseinrichtung 16 und die Sicherungseinrichtung 30 einander mit elastischen Kräften beaufschlagen und so einen Pressverbund ausbilden. Insbesondere kann die Sicherungseinrichtung 30 und beispielsweise deren Sicherungselement 32 die Führungseinrichtung 16 bewegungsübertragend mit der Rasteinrichtung 4 und der Gegenrasteinrichtung 5 verbinden, sodass sich die Rasteinrichtung 4, die Gegenrasteinrichtung 5, die Führungseinrichtung 16 und die Sicherungseinrichtung 30 nur gemeinsam auslenken oder verformen lassen, was ein Lösen der Halteverbindung zwischen dem Halteelement 13 und dem Gegenhalteelement 33 erschwert.

Wie insbesondere in der Figur 6 gut erkennbar, weist die Sicherungseinrichtung 30 und insbesondere deren Handhabungskopf 31 einen sich in der Längsrichtung D erstreckenden und die Längsrichtung D zumindest teilweise umlaufenden Kragen 41 auf. Der Kragen 41 ist im Wesentlichen komplementär zum Aufnahmekanal 21 ausgebildet und in diesen einsetzbar, um die Position des Handhabungskopf 31 im Aufnahmespalt A und insbesondere in der Einsetzöffnung E präzise zu definieren. Umlaufen der Rand 20 und somit auch der Aufnahmekanal 21 die Aufnahmerichtung R vollständig und umläuft auch der Kragen 41 die Längsrichtung D vollständig, so kann der in den Aufnahmekanal 21 eingesetzte Kragen 41 zusammen mit dem Rand 20 eine Dichteinrichtung 42 ausbilden.

Zwischen dem Kragen 41 und einen zentralen Abschnitt 43 des Handhabungskopfes 31 bildet der Handhabungskopf 31 einen Einsetzkanal 44 aus, in den der Rand 20 einsetzbar ist. Der sich in der Längsrichtung D öffnende Einsetzkanal 44 weist an seinen entgegen der Längsrichtung D angeordneten Grund eine Vertiefung 45 auf, die zusammen mit dem Einsatzkanal 44 zumindest teilweise oder sogar vollständig die Längsrichtung D umläuft. Die Vertiefung 45 definiert eine Sollbruchstelle, entlang der der zentrale Abschnitt 43 aus dem Handhabungskopf 31 ausgebrochen werden kann.

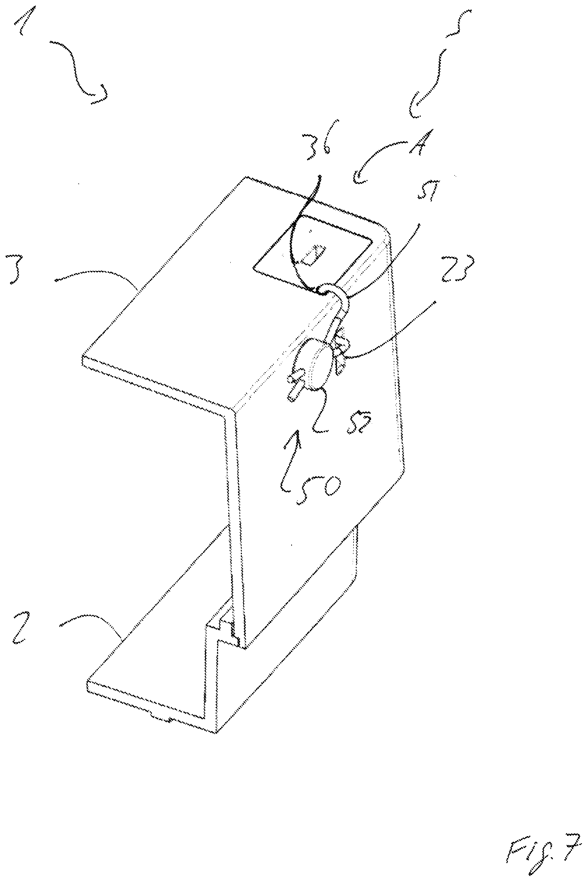

Figur 7 zeigt die Ausführungsbeispiele der Figuren 5 und 6 in der schematischen, teilweisen Perspektivansicht der Figur 5 mit einer weiteren Sicherungseinrichtung. Die Sicherungseinrichtung 30 ist auch in der Figur 7 in ihrer Sicherungsposition S innerhalb des Aufnahmespaltes A angeordnet dargestellt. Um ein unbefugtes Entfernen der Sicherungseinrichtung 30 und somit ein unbefugtes Öffnen des mehrteiligen Gehäuses 1 erkennen zu können, ist das mehrteilige Gehäuse 1 zusammen mit einer weiteren Sicherungseinrichtung 50 dargestellt. Die weitere Sicherungseinrichtung 50 weist einen Sicherungsfaden 51 auf, der durch die durchgehenden Öffnungen 23, 36 geführt ist. Freie Enden des Sicherungsfadens 51 sind mit einer Plombe 52 versehen.

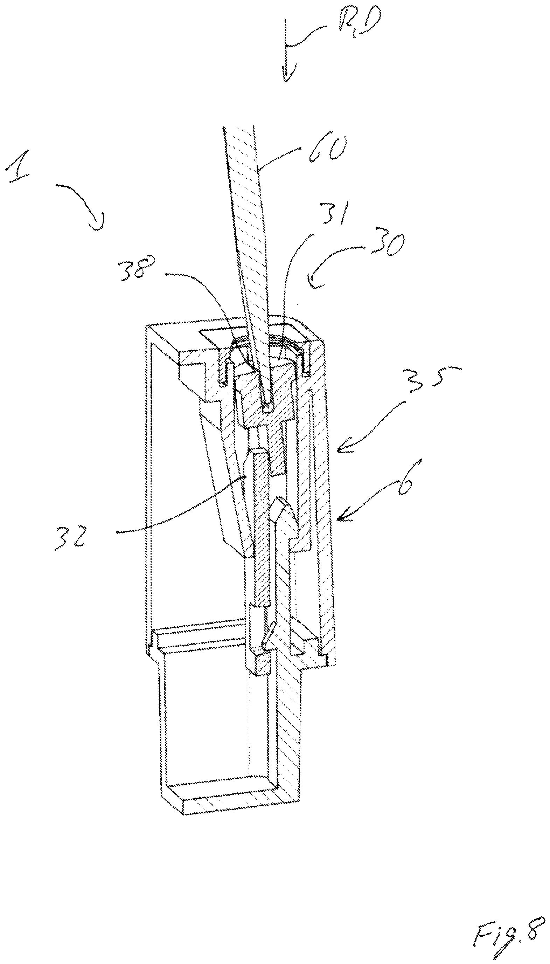

Figur 8 zeigt die Ausführungsbeispiele der Figuren 2 bis 7 in der schematischen Ansicht der 6. Gelegentlich ist das mehrteilige Gehäuse 1 zu öffnen, beispielsweise werden der Verbrauchszählers abgelesen, gewartet oder ausgetauscht werden muss. Um die Sicherung der Rastverbindung 6 durch die Sicherungseinrichtung 30 aufzuheben, kann die Sicherungseinrichtung 30 und insbesondere das Sicherungselement 32 zerbrochen werden. Beispielsweise kann das Sicherungselement 32 an der Sollbruchstelle 35 zerbrochen werden.

Gemäss der Figur 8 kann zum Zerbrechen der Sollbruchstelle 35 ein Werkzeug 60 in die Werkzeugaufnahme 38 eingesetzt und so quer zur Aufnahmerichtung R beziehungsweise zur Längsrichtung D geschwenkt werden das die Sollbruchstelle 25 überlastet und hierdurch zerbrochen wird. Die schenkende Bewegung des Werkzeugs 60 kann nämlich aufgrund des Formschlusses des Werkzeugs 60 mit der Werkzeugaufnahme 38 auf den Handhabungskopf 31 und von dort auf das Sicherungselement 32 übertragen werden. Der Handhabungskopf 31 kann dabei ebenfalls zerbrechen, beispielsweise entlang der Vertiefung des Aufnahmekanals 21.

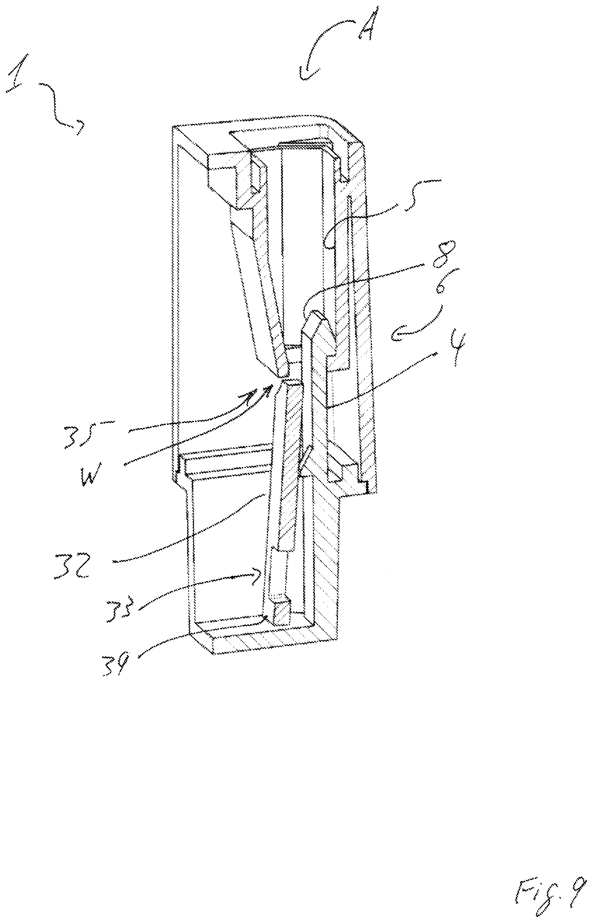

Figur 9 zeigt das Ausführungsbeispiel der Figur 8, wobei der Handhabungskopf 31 und das Werkzeug 60 vom mehrteiligen Gehäuse 1 entfernt sind. Aufgrund der Schwerkraft ist der sich zwischen der Sollbruchstelle 35 und dem Gegenhalteelement 33 beziehungsweise dem freien Ende 32 gelegene Abschnitt des Sicherungselementes 32 durch die Auswurföffnung W aus dem Aufnahmespalt A herausgefallen. Insbesondere befindet sich dieser Abschnitt des Sicherungselementes 32 nicht mehr quer zur Aufnahmerichtung R zwischen der Führungseinrichtung 16 und der Rasteinrichtung 4 beziehungsweise der Gegenrasteinrichtung 5, sodass die Rasteinrichtung 4 und insbesondere deren freies Ende 8 quer zur Aufnahmerichtung R weg von der Gegenrasteinrichtung 5 bewegbar ist, um die Rastverbindung 6 zu öffnen.

Sollte der abgebrochene Abschnitt des Sicherungselementes 32 nicht allein aufgrund der Schwerkraft durch die Auswurföffnung W fallen, etwa weil das mehrteilige Gehäuse 1 so angeordnet ist, dass die Auswurföffnung W nicht die untere Öffnung des Aufnahmespaltes A, sondern beispielsweise dessen seitliche oder obere Öffnung ist, oder weil die elastischen Kräfte der Führungseinrichtung 16 den abgebrochenen Abschnitt halten, kann der angebrochene Abschnitt einfach durch die Auswurföffnung hindurch gestossen werden, zum Beispiel mit dem Werkzeug 60, etwa wenn zumindest der zentralem Abschnitt 43 des Handhabungskopfes 31 aus dem Aufnahmespalt A entfernt wurde.

**Bezugszeichenliste**

| | | | |
|---|---|---|---|
| 1 | mehrteiliges Gehäuse | 33 | Gegenhalteelement |
| 2 | erstes Gehäuseteil | 34 | Gegenkodierelement |
| 3 | zweites Gehäuseteil | 35 | Sollbruchstelle |
| 4 | Rasteinrichtung | 36 | durchgehende Öffnung |
| 5 | Gegenrasteinrichtung | 37 | Oberseite |
| 6 | Rastverbindung | 38 | Werkzeugaufnahme |
| 7,9 | festes Ende | 39 | freies Ende |
| 8,10 | freies Ende | 40 | Gegenhaltefläche |
| 11 | Rastelement | 41 | Kragen |
| 12 | Gegenrastelement | 42 | Dichteinrichtung |
| 13 | Halteelement | 43 | zentraler Abschnitt |
| 14 | Haltefläche | 44 | Einsetzkanal |
| 15 | Führungsfläche | 45 | Vertiefung |
| 16 | Führungseinrichtung | 50 | weitere Sicherungseinrichtung |
| 17 | Führungsabschnitt | 51 | Sicherungsfaden |
| 18 | Führungsseite | 52 | Plombe |
| 19 | freies Ende | 60 | Werkzeug |
| 20 | Rand | | |
| 21 | Aufnahmekanal | A | Aufnahmespalt |
| 22 | Kodierelement | B | Bereitschaftsposition |
| 23 | durchgehende Öffnung | D | Längsrichtung |
| 24 | Seitenwand | E | Einsetzöffnung |
| 25 | Aussenseite | L | lichte Weite |
| 30 | Sicherungseinrichtung | R | Aufnahmerichtung |
| 31 | Handhabungskopf | S | Sicherungsposition |
| 32 | Sicherungselement | W | Auswurföffnung |

## Patentansprüche

1. Mehrteiliges Gehäuse (1) zur Aufnahme eines Verbrauchszählers, mit
einem eine Rasteinrichtung (4) aufweisenden ersten Gehäuseteil (2) und einem eine Gegenrasteinrichtung (5) aufweisenden zweiten Gehäuseteil (3), wobei
die Rasteinrichtung (4) und die Gegenrasteinrichtung (5) eine Rastverbindung (6) miteinander ausbilden, um das erste Gehäuseteil (2) und das zweite Gehäuseteil (3) aneinander zu fixieren,
**dadurch gekennzeichnet, dass**
die Rasteinrichtung (4) ein Halteelement (13) zum Halten einer die Rastverbindung (6) sichernden Sicherungseinrichtung (30) aufweist.

2. Mehrteiliges Gehäuse (1) nach Anspruch 1, **dadurch gekennzeichnet, dass** das Halteelement (13) ein von der Gegenrasteinrichtung (5) weg vorspringender Rastvorsprung ist.

3. Mehrteiliges Gehäuse (1) nach Anspruch 1 oder 2, **dadurch gekennzeichnet, dass** die Rasteinrichtung (4) ein freies Ende (7) und ein dem freien Ende (7) gegenüberliegendes festes Ende (8) aufweist, wobei das Halteelement (13) näher am festen Ende (8) als am freien Ende (7) angeordnet ist.

4. Mehrteiliges Gehäuse (1) nach Anspruch 3, **dadurch gekennzeichnet, dass** die Rasteinrichtung (4) ein Rastelement (11) zum Verrasten mit einem Gegenrastelement (12) der Gegenrasteinrichtung (5) aufweist, wobei das Rastelement (11) näher am freien Ende (7) als am festen Ende (8) angeordnet ist.

5. Mehrteiliges Gehäuse (1) nach einem der Ansprüche 1 bis 4, **dadurch gekennzeichnet, dass** das mehrteilige Gehäuse (1) eine Führungseinrichtung (16) für die Sicherungseinrichtung (30) aufweist, wobei die Führungseinrichtung (16) und die Rasteinrichtung (4) zumindest im geschlossenen Zustand der Rastverbindung (6) einen Aufnahmespalt (A) für die die Rastverbindung (6) sichernde Sicherungseinrichtung (30) quer zu einer Aufnahmerichtung (R) begrenzen, wobei der Aufnahmespalt (A) in der Aufnahmerichtung (R) verläuft.

6. Mehrteiliges Gehäuse (1) nach Anspruch 5, **dadurch gekennzeichnet, dass** die lichte Weite (L) des Aufnahmespaltes (A) in der Aufnahmerichtung (R) zumindest abschnittsweise abnimmt.

7. Mehrteiliges Gehäuse (1) nach Anspruch 5 oder 6, **dadurch gekennzeichnet, dass** der Aufnahmespalt (A) eine Einsetzöffnung (E) aufweist, wobei die Einsetzöffnung (E) vom ersten Gehäuseteil (2) weg weist.

8. Mehrteiliges Gehäuse (1) nach einem der Ansprüche 5 bis 7, **dadurch gekennzeichnet, dass** der Aufnahmespalt (A) eine Auswurföffnung (W) aufweist, die zum ersten Gehäuseteil (2) hin weist.

9. Mehrteiliges Gehäuse (1) nach einem der Ansprüche 5 bis 8, **dadurch gekennzeichnet, dass** die Rasteinrichtung (4), die Gegenrasteinrichtung (5) und die Führungseinrichtung (16) quer zur Aufnahmerichtung (R) jeweils zumindest abschnittsweise elastisch auslenkbar sind.

10. Mehrteiliges Gehäuse (1) nach einem der Ansprüche 5 bis 9, **dadurch gekennzeichnet, dass** das zweite Gehäuseteil (3) eine durchgehende Öffnung (23) aufweist, die die Umgebung des mehrteiligen Gehäuses (1) mit dem Aufnahmespalt (A) verbindet.

11. Mehrteiliges Gehäuse (1) nach einem der Ansprüche 7 bis 10, **dadurch gekennzeichnet, dass** das zweite Gehäuseteil (3) einen die Einsetzöffnung (E) quer zur Aufnahmerichtung (R) begrenzenden Rand (20) ausbildet, wobei der Rand (20) eine sich entgegen der Aufnahmerichtung (R) öffnenden und die Aufnahmerichtung (R) zumindest teilweise umlaufenden Aufnahmekanal (21) begrenzt.

12. Sicherungseinrichtung (30) zur Sicherung der Rastverbindung (6) des mehrteiligen Gehäuses (1) nach einem der Ansprüche 1 bis 11,
**dadurch gekennzeichnet, dass**
die Sicherungseinrichtung (30) einen Handhabungskopf (31) und ein Sicherungselement (32) aufweist, wobei das Sicherungselement (32) vom Handhabungskopf (31) entlang seiner Längsrichtung (D) vorspringt und ein quer zur Längsrichtung (D) verlaufendes Gegenhalteelement (33) zur Fixierung der Sicherungseinrichtung (30) in seiner Sicherungsposition (S) aufweist.

13. Sicherungseinrichtung (30) nach Anspruch 12, **dadurch gekennzeichnet, dass** das Sicherungselement (32) elastisch verformbar ist.

14. Sicherungseinrichtung (30) nach Anspruch 12 oder 13, **dadurch gekennzeichnet, dass** das Sicherungselement (32) eine Sollbruchstelle (35) aufweist, die ausgeformt ist, bei Belastung quer zur Längsrichtung (D) eher zu brechen, als an die Sollbruchstelle (35) angrenzende Abschnitte des Sicherungselementes (32).

15. Sicherungseinrichtung (30) nach einem der Ansprüche 12 bis 14, **dadurch gekennzeichnet, dass** der Handhabungskopf (31) einen sich in der Längsrichtung (D) öffnenden und die Längsrichtung (D) zumindest teilweise umlaufenden Kragen (41) aufweist.

## Claims

1. A multipart housing (1) for accommodating a consumption meter, comprising
a first housing part (2) having a latching device (4) and a second housing part (3) having a counter latching device (5),
the latching device (4) and the counter latching device (5) forming a latching connection (6) with each other in order to fix the first housing part (2) and the second housing part (3) to each other,
**characterized in that**
the latching device (4) has a retaining element (13) for retaining a securing device (30) that secures the latching connection (6).

2. The multipart housing (1) according to claim 1, **characterized in that** the retaining element (13) is a latching projection projecting away from the counter latching device (5).

3. The multipart housing (1) according to claim 1 or 2, **characterized in that** the latching device (4) has a free end (7) and a fixed end (8) opposite the free end (7), the retaining element (13) being arranged closer to the fixed end (8) than to the free end (7).

4. The multipart housing (1) according to claim 3, **characterized in that** the latching device (4) has a latching element (11) for latching with a counter latching element (12) of the counter latching device (5), the latching element (11) being arranged closer to the free end (7) than to the fixed end (8).

5. The multipart housing (1) according to any one of claims 1 to 4, **characterized in that** the multipart housing (1) has a guiding device (16) for the securing device (30), the guiding device (16) and the latching device (4), at least in the closed state of the latching connection (6), delimiting a receiving gap (A) for the securing device (30) that secures the latching connection (6) transversely with respect to a receiving direction (R), wherein the receiving gap (A) is running in the receiving direction (R).

6. The multipart housing (1) according to claim 5, **characterized in that** the clearance (L) of the receiving gap (A) decreases in the receiving direction (R) at least in sections.

7. The multipart housing (1) according to claim 5 or 6, **characterized in that** the receiving gap (A) has an insertion opening (E), wherein the insertion opening (E) faces away from the first housing part (2).

8. The multipart housing (1) according to any one of claims 5 to 7, **characterized in that** the receiving gap (A) has an ejection opening (W) which faces toward the first housing part (2).

9. The multipart housing (1) according to any one of claims 5 to 8, **characterized in that** the latching device (4), the counter latching device (5) and the guiding device (16) are each at least in sections elastically deflectable transversely with respect to the receiving direction (R).

10. The multipart housing (1) according to any one of claims 5 to 9, **characterized in that** the second housing part (3) has a continuous opening (23) which connects the surroundings of the multipart housing (1) to the receiving gap (A).

11. The multipart housing (1) according to any one of claims 7 to 10, **characterized in that** the second housing part (3) forms an edge (20) delimiting the insertion opening (E) transversely with respect to the receiving direction (R), wherein the edge (20) delimits a receiving channel (21) which opens counter to the receiving direction (R) and at least partially surrounds the receiving direction (R).

12. A securing device (30) for securing the latching connection (6) of the multipart housing (1) according to any one of claims 1 to 11,
**characterized in that**
the securing device (30) has a handling head (31) and a securing element (32), wherein the securing element (32) projects from the handling head (31) along its longitudinal direction (D) and has a counter retaining element (33) extending transversely with respect to the longitudinal direction (D) for fixing the securing device (30) in its securing position (S).

13. The securing device (30) according to claim 12, **characterized in that** the securing element (32) is elastically deformable.

14. The securing device (30) according to claim 12 or 13, **characterized in that** the securing element (32) has a predetermined breaking point (35) which is configured to break under load transversely with respect to the longitudinal direction (D) rather than at sections of the securing element (32) adjacent to the predetermined breaking point (35).

15. The securing device (30) according to any one of claims 12 to 14, **characterized in that** the handling head (31) has a collar (41) which opens in the longitudinal direction (D) and at least partially surrounds the longitudinal direction (D).

## Revendications

1. Boîtier en plusieurs parties (1) permettant de recevoir un compteur de consommation, comportant
une première partie de boîtier (2) présentant un dispositif d'encliquetage (4) et une seconde partie de boîtier (3) présentant un dispositif d'encliquetage complémentaire (5),
le dispositif d'encliquetage (4) et le dispositif d'encliquetage complémentaire (5) formant ensemble une liaison d'encliquetage (6) afin de fixer la première partie de boîtier (2) à la seconde partie de boîtier (3),
**caractérisé en ce que**
le dispositif d'encliquetage (4) comporte un élément de retenue (13) permettant de retenir un dispositif de blocage (30) bloquant la liaison d'encliquetage (6).

2. Boîtier en plusieurs parties (1) selon la revendication 1, **caractérisé en ce que** l'élément de retenue (13) est une saillie d'encliquetage dépassant du dispositif d'encliquetage complémentaire (5).

3. Boîtier en plusieurs parties (1) selon la revendication 1 ou 2, **caractérisé en ce que** le dispositif d'encliquetage (4) présente une extrémité libre (7) et une extrémité fixe (8) opposée à l'extrémité libre (7), l'élément de retenue (13) étant disposé plus proche de l'extrémité fixe (8) que de l'extrémité libre (7).

4. Boîtier en plusieurs parties (1) selon la revendication 3, **caractérisé en ce que** le dispositif d'encliquetage (4) comporte un élément d'encliquetage (11) permettant l'encliquetage avec un élément d'encliquetage complémentaire (12) du dispositif d'encliquetage complémentaire (5), l'élément d'encliquetage (11) étant disposé plus proche de l'extrémité libre (7) que de l'extrémité fixe (8).

5. Boîtier en plusieurs parties (1) selon l'une des revendications 1 à 4, **caractérisé en ce que** le boîtier en plusieurs parties (1) présente un dispositif de guidage (16) destiné au dispositif de blocage (30), le dispositif de guidage (16) et le dispositif d'encliquetage (4) délimitant, au moins dans l'état fermé de la liaison d'encliquetage (6), un espace de réception (A) destiné au dispositif de blocage (30) bloquant la liaison d'encliquetage (6) transversalement à une direction de réception (R), l'espace de réception (A) s'étendant dans la direction de réception (R).

6. Boîtier en plusieurs parties (1) selon la revendication 5, **caractérisé en ce que** la largeur libre (L) de l'espace de réception (A) diminue au moins par sections dans la direction de réception (R).

7. Boîtier en plusieurs parties (1) selon la revendication 5 ou 6, **caractérisé en ce que** l'espace de réception (A) présente une ouverture d'insertion (E), l'ouverture d'insertion (E) étant détournée de la première partie de boîtier (2).

8. Boîtier en plusieurs parties (1) selon l'une des revendications 5 à 7, **caractérisé en ce que** l'espace de réception (A) présente une ouverture d'éjection (W) qui pointe vers la première partie de boîtier (2).

9. Boîtier en plusieurs parties (1) selon l'une des revendications 5 à 8, **caractérisé en ce que** le dispositif d'encliquetage (4), le dispositif d'encliquetage complémentaire (5) et le dispositif de guidage (16) sont respectivement déformables élastiquement, au moins par sections, transversalement à la direction de réception (R).

10. Boîtier en plusieurs parties (1) selon l'une des revendications 5 à 9, **caractérisé en ce que** la seconde partie de boîtier (3) présente une ouverture continue (23) qui relie le périmètre du boîtier en plusieurs parties (1) à l'espace de réception (A).

11. Boîtier en plusieurs parties (1) selon l'une des revendications 7 à 10, **caractérisé en ce que** la seconde partie de boîtier (3) forme un bord (20) délimitant l'ouverture d'insertion (E) transversalement à la direction de réception (R), le bord (20) délimitant un canal de réception (21) s'ouvrant à l'encontre de la direction de réception (R) et étant au moins partiellement circonférentiel dans la direction de réception (R).

12. Dispositif de blocage (30) permettant de bloquer la liaison d'encliquetage (6) du boîtier en plusieurs parties (1) selon l'une des revendications 1 à 11,
**caractérisé en ce que**
le dispositif de blocage (30) comporte une tête de manipulation (31) et un élément de blocage (32), l'élément de blocage (32) faisant saillie depuis la tête de manipulation (31) le long de sa direction longitudinale (D) et présentant un élément de retenue complémentaire (33) s'étendant transversalement à la direction longitudinale (D) afin de fixer le dispositif de blocage (30) dans sa position de blocage (S).

13. Dispositif de blocage (30) selon la revendication 12, **caractérisé en ce que** l'élément de blocage (32) est déformable élastiquement.

14. Dispositif de blocage (30) selon la revendication 12 ou 13, **caractérisé en ce que** l'élément de blocage (32) présente un point de rupture de consigne (35) qui est créé pour se rompre lorsqu'il est chargé transversalement à la direction longitudinale (D) plutôt que les sections de l'élément de blocage (32) adjacentes au point de rupture de consigne (35).

15. Dispositif de blocage (30) selon l'une des revendications 12 à 14, **caractérisé en ce que** la tête de manipulation (31) présente une collerette (41) s'ouvrant dans la direction longitudinale (D) et étant au moins partiellement circonférentielle dans la direction longitudinale (D).
